# FASCICULE DE BREVET EUROPEEN

(11) **EP 0 854 204 B1**
(45) Date de publication et mention de la délivrance du brevet: **04.07.2001**
(21) Numéro de dépôt: 98400035.6
(22) Date de dépôt: 09.01.1998
(51) Int. Cl.: C23C 16/44, C23C 16/40

(54) **Procédé et installation d'élaboration d'un mélange gazeux comportant un gaz porteur, un gaz oxydant et un silane**
Verfahren und Vorrichtung zum Herstellen eines Gasgemisches enthaltend ein Trägergas, eine oxidierendes Gas und ein Silan
Process and apparatus for producing a gaseous mixture comprising a carrier gas, an oxidant gas and a silane

(30) Priorité: 15.01.1997 FR 9700344
(43) Date de publication de la demande: 22.07.1998
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Villermet, Alain, 78220 Viroflay (FR); Coeuret, François, 78280 Guyancourt (FR); Cocolios, Panayotis, 78830 Bullion (FR); Inizan, Michel, 78113 Conde sur Vesgre (FR)
(74) Mandataire: Mellul-Bendelac, Sylvie Lisette

(56) Documents cités:
- EP-A- 0 622 474
- US-A- 3 808 035
- US-A- 5 040 046
- US-A- 5 262 356
- STRATER: "Controlled oxidation of silane" RCA REVIEW., vol. 29, 1968, PRINCETON US, pages 618-629, XP002042377
- HAMMOND AND BOWERS: "Preparation and properties of SiO2 films deposited from SiH4 and O2" TRANSACTIONS OF THE METALLURGICAL SOCIETY OF AIME., vol. 242, 1968, NEW YORK US, pages 546-550, XP002042378

## Description

La présente invention concerne le domaine de la réalisation de mélanges gazeux comportant un silane et un oxydant, en particulier les mélanges ternaires gaz porteur/gaz oxydant/silane.

A titre d'exemple de technologie utilisant des atmosphères comportant ces trois types de gaz, on peut citer le cas des opérations de traitement de surface de substrats polymères, par dépôt, sous décharge électrique à barrière diélectrique, de films ou couches à base de silicium à la surface de tels substrats, dans le but notamment d'améliorer certaines propriétés de tels substrats polymères telles que leur mouillabilité par des encres ou encore par des adhésifs, mais également l'adhésion de ces encres ou adhésifs sur les substrats.

On doit entendre par la notion de « film » ou « couches » la réalisation d'un dépôt continu ou non, incluant donc le fait de ne déposer que des îlots isolés, pouvant ne couvrir par exemple que 10 à 15 % de la surface du film polymère.

On pourra se reporter aux documents EP-A-516 804 et EP-A-622 474, tous deux au nom de la demanderesse, qui concernent de tels procédés de dépôts de films à base de silicium sur substrats polymères.

Les propriétés très particulières des silanes, font qu'il est en pratique très difficile et coûteux de réaliser et manipuler de tels mélanges ternaires.

Ces propriétés sont bien connues de l'homme du métier, on rappellera simplement ici brièvement, en prenant l'exemple du monosilane (le plus souvent appelé « silane » tout court) que les difficultés de manipulation du silane sont liées à deux aspects:

### a) Son auto-inflammation en présence d'oxygène :

Cette propriété d'auto-inflammation rend la manipulation du silane difficile et coûteuse, du fait qu'il est nécessaire d'utiliser des installations étanches mettant en oeuvre des vannes d'isolement et autres circuits de purges.

A titre illustratif, l'auto-inflammation du monosilane va dépendre de nombreux paramètres tels que pression d'alimentation du gaz, température, vitesse d'éjection du gaz, ou encore hygrométrie. La limite de concentration du monosilane dans un gaz porteur, généralement reconnue dans la littérature, au delà de laquelle les mélanges seront considérés comme inflammables ou spontanément inflammables, se situe selon les ouvrages entre 1 et 4 %.

### b) La formation de particules :

Le fait de mettre en présence un silane et un oxydant peut entraîner la formation de particules de silice. Ces particules, en s'accumulant, peuvent non seulement obstruer les canalisations (donc augmenter dangereusement la pression en amont), mais par ailleurs endommager les différents éléments qui composent l'installation tels que vannes, régulateurs de débit, ou autres détendeurs.

Concernant la stabilité de mélanges comportant un silane et un oxydant, on pourra notamment se reporter à l'article au nom de K Strater, paru dans RCA review en décembre 1968, où l'auteur s'intéresse à la stabilité de mélanges O₂/N₂/SiH₄, CO₂/N₂/SiH₄, N₂O/N₂/SiH₄, et où il démontre que la stabilité de tels mélanges à température ambiante est démontrée jusqu'à 0.8 % de monosilane dans le mélange.

Ces résultats peuvent suggérer les commentaires suivants :
- d'une part, on peut faire observer que cette limite haute de stabilité est trop faible pour certaines applications mettant en oeuvre du silane et un oxydant, et pour lesquelles une concentration en silane dans le mélange plus élevée est requise;
- selon les matériels utilisés, il apparaît difficile de prendre le risque de former de la poudre de silice, sachant que localement, pour des raisons d'homogénéité du mélange, on peut se situer au delà de cette limite de 0.8 %.

A titre d'exemple, l'utilisation courante de régulateurs de débit massique (« mass-flow-controllers » en anglais), mettant en oeuvre un capillaire, semble très risquée, même en deçà de la limite de concentration avancée par cet article de K Strater.

De façon cohérente avec ces résultats, on peut citer un autre exemple de la littérature, au nom de M. L. Hammond et M. G. Bowers (paru dans Transactions of the Metallurgical Society of AIME, March 1968), et qui concerne le dépôt CVD de couches de silice sur des wafers, à partir de mélanges O₂/N₂/SiH₄. L'appareillage utilisé pour réaliser les mélanges met en oeuvre un traditionnel panneau de distribution de gaz, où parviennent les trois lignes de gaz, les mélanges fabriqués ainsi ayant une teneur en silane variant de 0.06 à 0.3 % volumiques, donc des teneurs très faibles en silane.

En considérant à nouveau l'exemple du dépôt de films à base de silicium sur substrats polymères, par décharge électrique à barrière diélectrique, on constate alors qu'en pratique, plutôt que de pré-effectuer le mélange, on préfère envoyer les différents gaz constituant l'atmosphère séparément en différents points de la zone de décharge électrique.

On conçoit alors que de telles injections séparées des différents composants de l'atmosphère requise donnent lieu à des variations importantes de composition de l'atmosphère de traitement dans l'espace de décharge, ce qui ne permet pas d'atteindre un réel contrôle de la composition de l'atmosphère et donc une réelle reproductibilité de la qualité du traitement du film.

Les travaux menés à bien par la Demanderesse, en particulier pour l'exemple d'installations de traitement de surfaces de films polymères, montrent que la mise en statique des mélanges gazeux peut être fréquente et de relative longue durée. En effet, il est courant que l'utilisateur mette sa ligne de production/transformation à l'arrêt, par exemple lors d'une opération de maintenance, ou de changement de type de film à traiter, ou encore de problèmes mécaniques, le traitement de surface étant alors interrompu, ce qui entraîne l'arrêt des débits gazeux et donc la mise en statique des mélanges gazeux effectués antérieurement à l'arrêt, dans une large portion des canalisations.

La présente invention a notamment pour objectif d'apporter une solution aux problèmes techniques ci-dessus évoqués.

Les travaux menés à bien par la Demanderesse dans ce domaine ont permis de mettre en évidence qu'il est possible d'apporter une telle solution technique par la mise en oeuvre combinée des étapes suivantes :
- réaliser le mélange gazeux final (qui comporte donc un gaz porteur, par exemple neutre ou encore un mélange d'un gaz neutre et d'un gaz réducteur comme l'hydrogène, un gaz oxydant, et un silane), en au moins deux étapes, en réalisant d'abord un mélange gazeux que l'on peut qualifier de « primaire » qui comporte un gaz neutre et le silane, la teneur en silane du mélange gazeux primaire étant inférieure à la limite d'auto-inflammation du silane dans l'air ;
- on mélange le mélange gazeux primaire ainsi constitué à un courant du gaz porteur et le cas échéant un courant du gaz oxydant (selon la teneur résiduelle du gaz porteur en gaz oxydant), dans des proportions permettant d'obtenir le mélange final requis, l'adjonction du courant de mélange primaire, ou du courant de gaz oxydant pour réaliser ce mélange final étant effectuée en mode dynamique.

On doit entendre ici par l'expression « mode dynamique » le fait que l'étape d'adjonction du courant de mélange primaire ou de gaz oxydant pour réaliser le mélange gazeux final est effectuée dans des conditions où les débits gazeux mis en oeuvre ne sont jamais nuls, et en évitant tout volume mort, toute zone de stagnation ou de recirculation de gaz, qui pourrait favoriser une réaction entre les deux espèces.

On illustrera plus loin des exemples de réalisation de telles adjonctions en mode dynamique, on verra alors qu'il est tout particulièrement recommandé d'éviter l'utilisation des traditionnelles capacités tampons pour réaliser un tel mélange ternaire.

Le procédé selon l'invention d'élaboration d'un mélange gazeux final comportant un gaz porteur, un gaz oxydant et un silane, à teneur déterminée en chacun des trois composants gazeux, comprend alors la mise en oeuvre des étapes suivantes :
a) on réalise un mélange gazeux primaire comportant un second gaz neutre et ledit silane, la teneur en silane du mélange gazeux primaire étant inférieure à la limite d'auto-inflammation du silane considéré dans l'air ;
b) on dispose d'un premier courant de gaz, comportant ledit gaz porteur, à teneur résiduelle contrôlée en le dit gaz oxydant;
c) on réalise le mélange final requis selon l'une ou l'autre des deux procédures suivantes, en fonction de la teneur résiduelle en gaz oxydant dudit premier courant de gaz comportant ledit gaz porteur :
   P1 : on mélange ledit premier courant de gaz à un second courant dudit mélange gazeux primaire et à un troisième courant du gaz oxydant, dans des proportions permettant d'obtenir le mélange final requis, l'adjonction du courant de gaz oxydant étant effectuée en mode dynamique;
   P2 : on mélange le dit premier courant de gaz à un second courant dudit mélange gazeux primaire, dans des proportions permettant d'obtenir le mélange final requis, l'adjonction du courant de gaz primaire étant effectuée en mode dynamique.

Selon une des mises en oeuvre de l'invention, le mélange selon la procédure P1 est réalisé en deux étapes :
i) on réalise un mélange intermédiaire, entre ledit premier courant de gaz et le dit second courant de mélange gazeux primaire;
ii) on adjoint ledit troisième courant du gaz oxydant au mélange intermédiaire dans des proportions permettant d'obtenir le mélange final requis.

De façon avantageuse, on réalisera une homogénéisation du mélange final réalisé selon l'invention, par le fait que la canalisation où circule ledit premier courant de gaz adopte, en aval des points d'adjonction dudit second courant de mélange primaire et dudit troisième courant du gaz oxydant, dans le cas de la procédure P1, ou en aval du point d'adjonction dudit second courant de mélange gazeux primaire, dans le cas de la procédure P2, une forme de serpentin.

Comme signalé précédemment, le premier courant de gaz comporte le gaz porteur, « gaz porteur » selon l'invention qui peut par exemple être un gaz neutre (tel que par exemple l'azote, l'argon encore l'hélium) ou encore un mélange d'un gaz neutre et d'un gaz réducteur tel l'hydrogène.

Comme on l'aura compris à la lecture de ce qui précède, on a utilisé la terminologie « second gaz neutre » pour évoquer la composition du mélange primaire, afin de clairement signifier le fait que le gaz neutre entrant dans la composition du mélange primaire peut être différent du gaz neutre entrant dans la composition du gaz porteur.

Selon une des mises en oeuvre de l'invention, ledit premier courant de gaz est un courant d'azote d'origine cryogénique.

Selon une autre mise en oeuvre de l'invention, ledit premier courant de gaz est un courant d'azote impur obtenu par séparation d'air par perméation ou adsorption, comportant une teneur résiduelle en oxygène. La teneur résiduelle en oxygène d'un tel premier courant de gaz est alors avantageusement comprise entre 0,1 % et 12 % volumiques.

Selon une autre mise en oeuvre de l'invention ledit premier courant de gaz est un courant d'air sec.

Selon une des mises en oeuvre de l'invention, ledit courant de gaz comportant le gaz porteur est un gaz neutre et l'on utilise alors, à titre de second gaz neutre participant à l'élaboration du mélange primaire, le même gaz neutre que celui constituant le gaz porteur.

A titre de « silane » pouvant être mis en oeuvre dans le cadre de la présente invention, on peut citer les hydrures de silicium linéaires ou ramifiés de formules SiₙH₂ₙ₊₂. où n représente un nombre compris entre 1 et 4, tels le monosilane (SiH₄), le disilane ou le trisilane, les hydrures de silicium halogénés telles SlCl₄, SiH₂Cl₂, SiHCl₃, SiH₃Cl, ou encore SiHCl₃, les alkoxysilanes tel le tétraethoxysilane, ou encore les organo-siloxanes.

Selon un des aspects de l'invention, le silane utilisé est du monosilane.

Comme il apparaîtra également clairement à l'homme du métier, le « gaz oxydant » selon l'invention pourra être très varié selon l'application du mélange final considérée. On peut néanmoins citer ici à titre illustratif l'oxygène, CO₂, N₂O, NO₂, ou encore des mélanges de tels gaz oxydants.

Selon un des aspects de l'invention, le gaz oxydant mis en oeuvre est l'oxygène ou un gaz comportant de l'oxygène tel que l'air.

Selon une des mises en oeuvre de l'invention, le mélange gazeux final obtenu est dirigé vers au moins un point utilisateur où est pratiquée une opération de traitement de surface de films polymères par dépôt sous décharge électrique à barrière diélectrique d'une couche à base de silicium sur le film.

On doit entendre selon l'invention par l'expression « couche » (déposée sur le film) la notion déjà rappelée plus haut dans la présente demande.

Comme il apparaîtra clairement à l'homme du métier à la lecture de tout ce qui précède, le procédé de réalisation d'un mélange selon l'invention permet de s'adapter aux différentes sources de gaz disponibles sur le marché des gaz (ainsi par exemple aux mélanges prééffectués, aux mélanges effectués sur site, à la production d'azote sur site par séparation d'air par perméation ou adsorption etc...), et donc en particulier à l'éventuelle teneur résiduelle en un gaz oxydant du courant de gaz qui comprend le gaz porteur.

Ainsi par exemple dans le cas déjà signalé où le premier courant de gaz est un courant d'azote d'origine cryogénique, donc presque dépourvu d'impuretés (teneur en oxygène inférieure à 10 voire 5 ppm), on appliquera avantageusement la procédure P1 par adjonction, au courant d'azote cryogénique, d'un second courant de mélange gazeux primaire et d'un troisième courant de gaz oxydant dans les conditions déjà décrites (le gaz oxydant pourra par exemple être de l'oxygène, de l'air, une source de N₂O etc...).

Toujours à titre d'exemple, dans le cas où le premier courant de gaz est un courant d'azote impur obtenu par séparation d'air par perméation ou adsorption, donc comportant une teneur résiduelle en oxygène significative, on appliquera avantageusement la procédure P2 (en utilisant donc la réserve d'oxydant déjà contenue dans le premier courant de gaz), par adjonction au courant d'azote impur, d'un second courant du mélange gazeux primaire, dans les conditions déjà décrites.

A titre de troisième exempte, dans le cas où le premier courant de gaz est un courant d'air sec, comportant donc près de 21 % d'oxygène, on appliquera avantageusement la procédure P2 comme précédemment décrit.

On conçoit donc qu'il est possible de s'adapter à toutes les situations de gaz, en adoptant selon les cas la procédure P1 ou la procédure P2 afin de réaliser le mélange final dans les conditions dynamiques requises.

Comme il apparaîtra également clairement à l'homme du métier, le mélange « final » gaz porteur/silane/gaz oxydant selon l'invention pourra être de composition très variable et adaptable selon l'application visée.

A titre illustratif, en prenant l'exemple des mélanges utilisés pour des dépôts de films à base de silicium sur substrat polymère, on pourra envisager par exemple les mélanges suivants :
- ex1 : un mélange final (débit de quelques dizaines de Nm³/h) N₂/SiH₄/N₂O, dont la teneur en silane soit comprise entre 100 et 5000 ppm, et dont la teneur en N₂O soit avantageusement 2 à 4 fois celle du silane dans le mélange, le mélange ayant été obtenu selon la procédure P1 à partir d'un premier courant de gaz d'azote d'origine cryogénique, un second courant de mélange primaire azote/silane prééffectué (teneur en silane inférieure à 1,9 %), et un courant de protoxyde d'azote, dans des proportions permettant d'atteindre la composition finale souhaitée, l'adjonction du courant de protoxyde d'azote étant réalisée en mode dynamique.
- ex2 : un mélange final (débit de quelques dizaines de Nm³/h) N₂/SiH₄/O₂, dont la teneur en silane soit comprise entre 100 et 5000 ppm, et dont la teneur en oxygène sera choisie largement en excès par rapport à celle du silane dans le mélange, le mélange ayant été obtenu selon la procédure P2 à partir d'un premier courant de gaz d'azote obtenu par séparation d'air par perméation, et d'un second courant de mélange primaire azote/silane prééffectué (teneur en silane inférieure à 1,9 %), dans des proportions permettant d'atteindre la composition finale souhaitée, l'adjonction du courant de mélange primaire étant réalisée en mode dynamique.

D'autres caractéristiques et avantages de la présente invention ressortiront de la description suivante de modes de réalisation donnée à titre illustratif et nullement limitatif faite en relation avec les dessins annexés, sur lesquels :
- la figure 1 est une représentation schématique d'une installation convenant pour la mise en oeuvre du procédé selon l'invention ;
- la figure 2 est une représentation schématique d'une autre installation convenant pour la mise en oeuvre du procédé selon l'invention ;
- la figure 3 est une représentation détaillée d'un mode de réalisation de l'étape de mélange « en dynamique » gaz porteur/gaz oxydant/silane selon l'invention (détail du rectangle référencé 15 au niveau de la figure 1);
- la figure 4 est un exemple de résultats obtenus en terme de tension de surface, de films polymères de type BOPP (« Bi Oriented PolyPropylene »), traités à l'aide de mélanges gazeux réalisés selon l'invention.

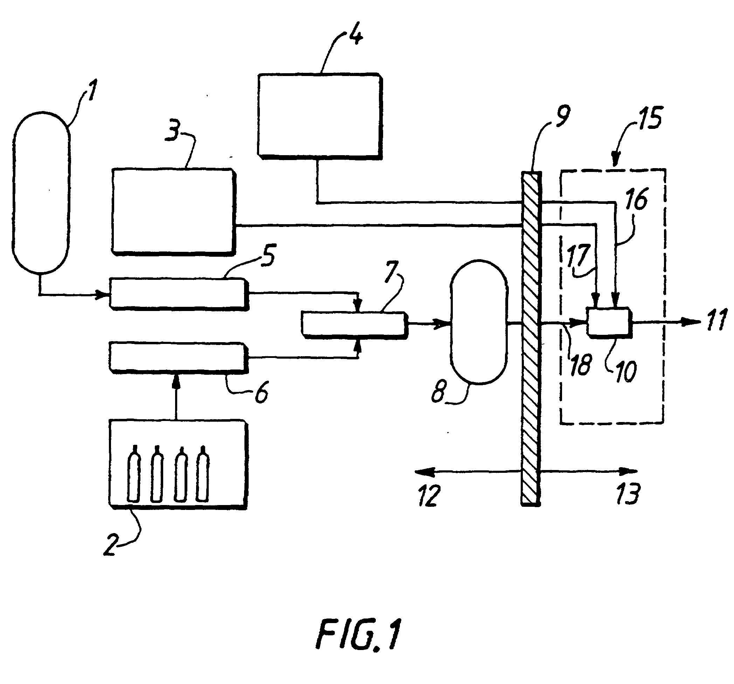

La figure 1 illustre le cas d'une installation convenant pour la mise en oeuvre du procédé selon l'invention, utilisée avec succès pour l'alimentation d'un traiteur de films polymères.

On reconnaît sur la figure 1 une source 1 de gaz neutre (par exemple une réserve d'azote cryogénique), et une source 2 de monosilane à l'état gazeux (par exemple des stockages en bouteilles de monosilane pur).

Les références 5 et 6 sur le schéma représentent respectivement des moyens de distribution du gaz neutre et du monosilane, connus de l'homme du métier et qui ne seront donc pas détaillés ici, permettant d'alimenter un mélangeur 7 afin de réaliser le mélange gazeux primaire (à teneur en silane inférieure à l'auto-inflammation du silane dans l'air), et de stocker le mélange gazeux primaire ainsi formé dans une capacité tampon 8.

On notera que l'utilisation ici d'une telle capacité tampon se révèle tout à fait avantageuse pour pouvoir fournir en continu le mélange final requis à un traiteur 11, ceci même quand l'approvisionnement en gaz en amont de la ligne est pour une raison ou pour une autre provisoirement interrompu : par exemple dans les cas de remplissage du stockage 1 d'azote liquide, ou encore dans le cas où l'on est en train de changer les bouteilles de silane au niveau de la source 2.

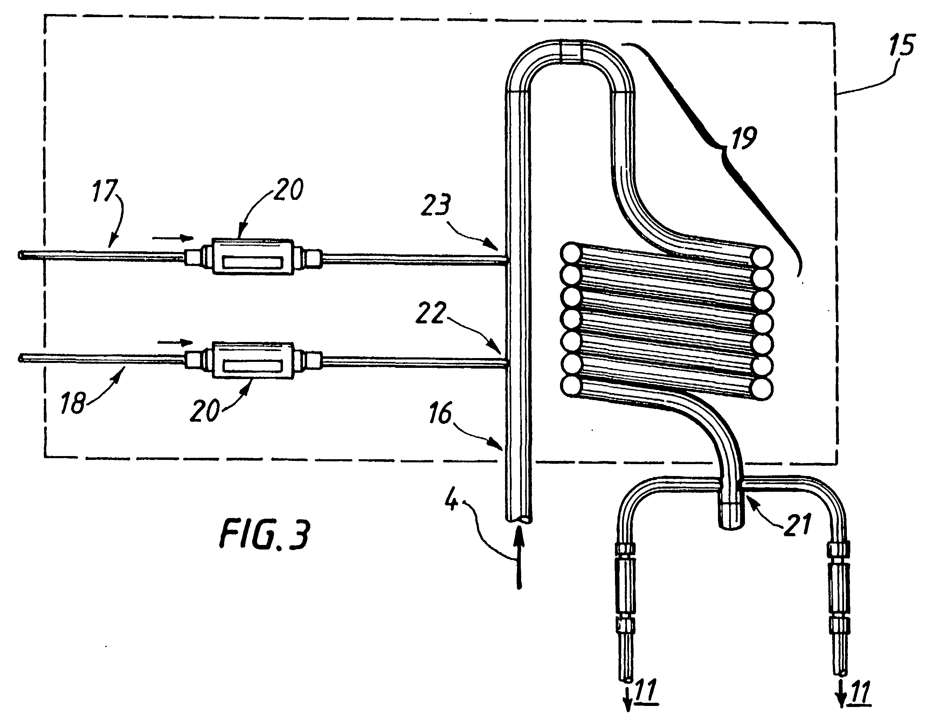

La capacité tampon 8 alimente en mélange gazeux primaire, via la ligne de gaz 18, la zone de mélange référencée 15 sur la figure (qui sera détaillée plus loin dans le cadre de la figure 3), zone 15 qui est par ailleurs alimentée en gaz oxydant en provenance de la source 3 via la ligne de gaz 17, et en gaz qui comporte le gaz porteur en provenance de la source 4 via la ligne de gaz 16.

On a symbolisé par la référence 9 ce qui peut constituer un mur extérieur du site utilisateur où se trouve le traiteur 11, afin d'illustrer un mode de réalisation particulier pour lequel l'étape de pré-dilution (7) est réalisée à l'extérieur (12) du site utilisateur, alors que le mélange final entre le mélange gazeux primaire, le gaz oxydant, et le gaz porteur est réalisé à l'intérieur (13) du site utilisateur.

A titre illustratif, on peut utiliser ici deux sources de gaz neutre différentes : la première source 1 qui peut être par exemple constituée de cadres de bouteilles d'azote, et une seconde source 4, qui peut être par exemple constituée d'azote liquide.

Cette mise en oeuvre de deux sources de gaz neutre différentes répond notamment à la législation de certains pays (par exemple la France) où la manipulation de mélanges neutre/silane exige deux sources différentes de gaz neutre, dès que le gaz neutre est également utilisé pour d'autre applications d'inertage sur le site:
- une première source pour réaliser le mélange neutre/silane ;
- une seconde source non seulement pour compléter le mélange afin d'atteindre la composition désirée mais aussi pour alimenter les autres applications du site ;
ceci pour éviter, dans le cas d'éventuelles remontées de silane dans la canalisation de gaz neutre, d'alimenter les autres points du site utilisateur qui nécessitent de l'azote pour des applications d'inertage (en particulier du point de vue sécuritaire) avec un mélange comportant en fait du silane.

On a représenté ici un cas où les sources 3 et 4 sont séparées. Comme signalé précédemment, on peut également envisager selon l'invention de réunir les sources 3 et 4 en une unique source de gaz qui comprend le gaz porteur et une certaine concentration résiduelle en le gaz oxydant, qui peut par exemple être obtenue par un séparateur d'air par adsorption ou perméation.

Toujours à titre illustratif, on peut citer d'autres sources de gaz convenant pour la constitution des sources 3 et 4.

Ainsi, en considérant le cas de la source de gaz oxydant 3, si comme déjà signalé, on peut utiliser une source "simple" telle un mélange préeffectué d'un ou plusieurs gaz oxydants dans un gaz porteur, ou encore un séparateur d'air par perméation ou adsorption fournissant de l'azote à teneur donnée et contrôlée en oxygène, on peut aussi envisager (selon les ressources du site utilisateur concerné), l'utilisation de sources plus "élaborées" telle un azote comportant une teneur contrôlée en CO₂ et H₂O, résultant de la réaction catalysée à basse température entre un hydrocarbure et un azote impur comportant de l'oxygène produit par séparation d'air par perméation ou adsorption.

De même, en considérant le cas de la source de gaz porteur 4, si des sources simples peuvent être envisagées telles une source de gaz neutre produit par voie cryogénique, d'autres types de sources peuvent être également envisagées selon les ressources du site utilisateur, telles que un azote pur obtenu par désoxygénation catalytique d'un azote primaire impur produit par séparation d'air par perméation ou adsorption, par exemple de la façon suivante :
- on fait réagir l'azote impur (en oxygène) avec de l'hydrogène sur un catalyseur au platine pour former un azote comportant de la vapeur d'eau et moins de 10 ppm d'oxygène résiduel, vapeur d'eau éliminée en aval sur un sécheur;
- on fait réagir l'azote impur (en oxygène) avec un hydrocarbure sur un catalyseur au platine, à basse température, pour former un azote comportant du CO₂, de la vapeur d'eau, et éventuellement des traces d'hydrocarbure résiduel s'il a été utilisé en excès, CO₂ et H₂O que l'on élimine en aval sur des moyens d'épuration appropriés.

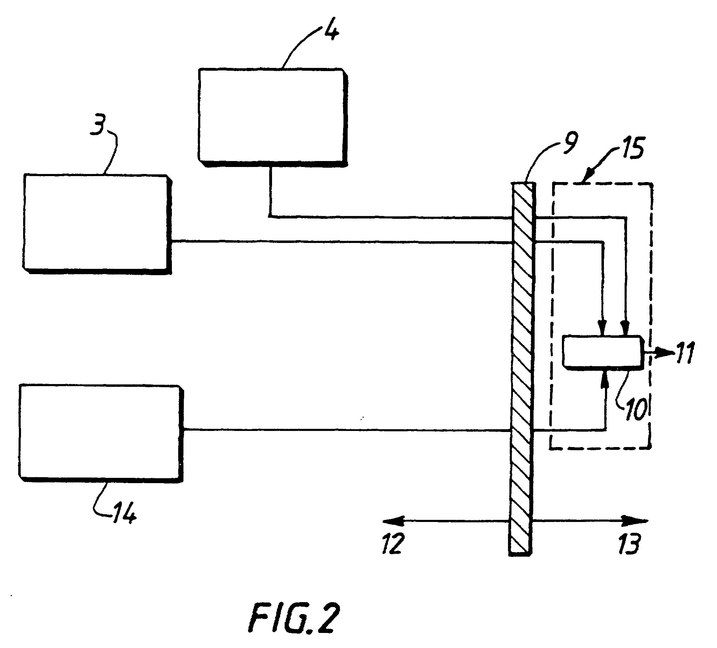

La figure 2 illustre une autre installation convenant pour la mise en oeuvre du procédé, dont la conception est proche de celle représentée dans le cadre de la figure 1, mais en a été simplifiée par le fait que le mélange gazeux primaire dilué en silane n'est pas fabriqué sur site comme dans le cas de la figure 1, mais est déjà disponible au niveau d'une source 14, par exemple constitué de bouteilles de mélange azote/silane à 2 % de silane dans l'azote.

On constate également pour ce mode de réalisation l'absence de capacité tampon 8, mais on pourra par exemple (pour assurer la sécurité/continuité d'approvisionnement évoquée dans le cadre de la figure 1) utiliser 2 ou plusieurs cadres de bouteilles en parallèle, avec renouvellement des cadres utilisés au fur et à mesure.

Les mêmes remarques peuvent être effectuées ici, concernant la diversité des sources possibles 3 et 4, que celles déjà effectuées dans le cadre de la figure 1.

La figure 3 illustre un mode de réalisation particulier de la zone de mélange 15 en dynamique, mélange réalisé entre le mélange gazeux primaire neutre/silane (à teneur en silane inférieur à la limite d'auto-inflammation du silane dans l'air), parvenant à la zone de mélange via la canalisation 18, le gaz oxydant (par exemple de l'oxygène), parvenant à la zone de mélange via la canalisation 17, et un courant de gaz comportant le gaz parvenant à la zone de mélange via la canalisation 16.

Comme détaillé plus loin dans le cadre d'exemples, les canalisations ont été dimensionnées pour tenir compte d'un débit de gaz porteur 4 supérieur voire dans certains cas très largement supérieur au débit mis en oeuvre dans les canalisations 17 et 18, compte tenu de la composition du mélange final requis, mais également de façon à s'assurer que la vitesse de gaz dans la canalisation principale 16 (porteur) puisse être supérieure à la vitesse de gaz dans les autres canalisations.

De façon plus détaillée, en revenant aux cas de la procédure P1 et de la procédure P2 :
- dans le cas de la procédure P1 : on assurera préférentiellement une vitesse de gaz dans la canalisation principale (gaz porteur) supérieure à la vitesse de gaz dans la canalisation « gaz oxydant », voire supérieure à la vitesse de gaz dans les deux autres canalisations gaz oxydant et gaz primaire;
- dans le cas de la procédure P2 : on assurera préférentiellement une vitesse de gaz dans la canalisation principale (gaz porteur) supérieure à la vitesse de gaz dans la canalisation « mélange primaire ».

On adoptera alors préférentiellement un facteur **X** entre la vitesse de gaz dans la canalisation principale et la ou les (selon les cas mentionnés ci-dessus) vitesse (s) de gaz dans la ou les autres canalisations, supérieur à 1, et se situant avantageusement à un ordre de grandeur de plusieurs dizaines, voire plusieurs centaines. Ainsi à titre illustratif, dans le cas P1, un facteur **X** de 100 ou même 200, entre la vitesse de gaz dans la canalisation principale (gaz porteur) et la vitesse de gaz dans la canalisation « gaz oxydant » a été utilisé avec succès pour réaliser des mélanges ternaires azote/silane/protoxyde d'azote, en dynamique.

On constate alors, en revenant à la figure 3, que l'adjonction de gaz oxydant dans la canalisation 16 est immédiatement entraînée par le fort débit de gaz porteur circulant dans la canalisation 16, sans qu'à aucun moment, le silane (provenant de la canalisation 18) et le gaz oxydant (provenant de la canalisation 17) ne puissent stagner dans cette canalisation 16, ce qui favoriserait la formation de poudre de silice entre ces deux espèces.

L'adjonction de gaz oxydant ayant ainsi été réalisée en mode parfaitement dynamique, un complément d'homogénéisation entre les trois espèces est réalisé dans l'installation par le fait que la canalisation 16 adopte, en aval des points de raccordement 22 et 23 des canalisations 17 et 18, une structure de serpentin (schématisée en 19), dans les spires duquel le mélange circule, sans jamais à aucun moment rencontrer d'angles, ou de zones mortes de stagnation ou de recirculation, favorisant ainsi une homogénéisation parfaite du mélange final requis, avant que celui-ci n'atteigne le point symbolisé 21 de l'installation, où le mélange final peut être distribué vers le ou les point(s) utilisateur(s) du site.

On a illustré sur cette figure 3 l'exemple d'un cas où le mélange final est distribué vers deux traiteurs du site utilisateur ou encore vers deux points d'injection d'un même traiteur 11.

On le voit donc, le mode de réalisation illustré dans le cadre de cette figure 3 permet de réaliser dans des conditions parfaitement dynamiques, d'une part l'adjonction du courant de gaz oxydant dans le mélange comportant le silane mais également l'homogénéisation éventuelle du milieu gazeux ternaire ainsi formé.

Cette figure 3 n'illustre qu'un des modes de réalisation envisageables pour obtenir un tel résultat, on peut citer également à titre illustratif les mélangeurs commercialisés par la société SULZER CHEMTECH.

Selon un mode avantageux de mise en oeuvre de l'invention, la mise en contact, entre le mélange primaire comportant le silane et le gaz oxydant, sera effectuée dans l'installation, en un point aussi proche que possible du point utilisateur 11. On comprend en effet que dans une telle configuration, l'arrêt du traiteur 11 (par exemple dans le cas d'un arrêt de la ligne de production/ transformation, ou encore dans un cas où l'on doit changer le film polymère à traiter), qui entraînera généralement l'arrêt des alimentations en gaz en provenance des différentes sources du site, et la purge des canalisations. En adoptant un tel mode de mise en oeuvre seuls quelques mètres de canalisations comportant le silane et l'oxydant seront potentiellement concernés par une formation de poudre et donc à purger.

Pour un premier exemple de mise en oeuvre, une installation telle que celle décrite dans le cadre de la figure 2, incorporant une zone de mélange 15 telle que celle détaillée dans le cadre de la figure 3, a été utilisée pour alimenter en mélange azote/oxygène/silane une installation de traitement de surface de films en polypropylène.

L'installation traitait des films de polypropylène bi-orientés, de largeur voisine de 1m, la vitesse de défilement du film dans le traiteur étant en moyenne de 50 m/min.

Le mélange ternaire souhaité devait comporter 200 ppm de silane et environ 5 % d'oxygène.

L'installation de la figure 2 a été dans ce cas mise en oeuvre à l'aide d'une source 14 de monosilane SiH₄ constituée de bouteilles de SiH₄ à 1,9 % dans l'azote (débit en production : 370 l/h), et des sources 3 et 4 réunies en une source unique, constituée d'un séparateur d'air par voie membranaire produisant un azote impur à 95 %, donc comportant une teneur résiduelle en oxygène de 5 % (débit de gaz oxydant en production : 35 Nm³/h), pour une teneur en silane dans le mélange global de 200 ppm.

Pour un second exemple de mise en oeuvre, une installation telle que celle décrite dans le cadre de la figure 2, incorporant une zone de mélange 15 telle que celle détaillée dans le cadre de la figure 3, a été utilisée pour alimenter en mélange azote/N₂O/silane la même installation de traitement de surface de films en polypropylène que celle considérée dans le cadre de l'exemple 1 (films de BOPP de largeur voisine de 1m, défilant dans le traiteur en moyenne à 50 m/min).

Le mélange ternaire souhaité devait comporter 200 ppm de silane et 800 ppm de N₂O.

L'installation de la figure 2 a été dans ce cas mise en oeuvre à l'aide d'une source 14 de monosilane SiH₄ constituée de bouteilles de SiH₄ à 1,9 % dans l'azote, et une source 3 de gaz oxydant constituée de bouteilles de gaz N₂O, la source 4 étant une réserve d'azote d'origine cryogénique

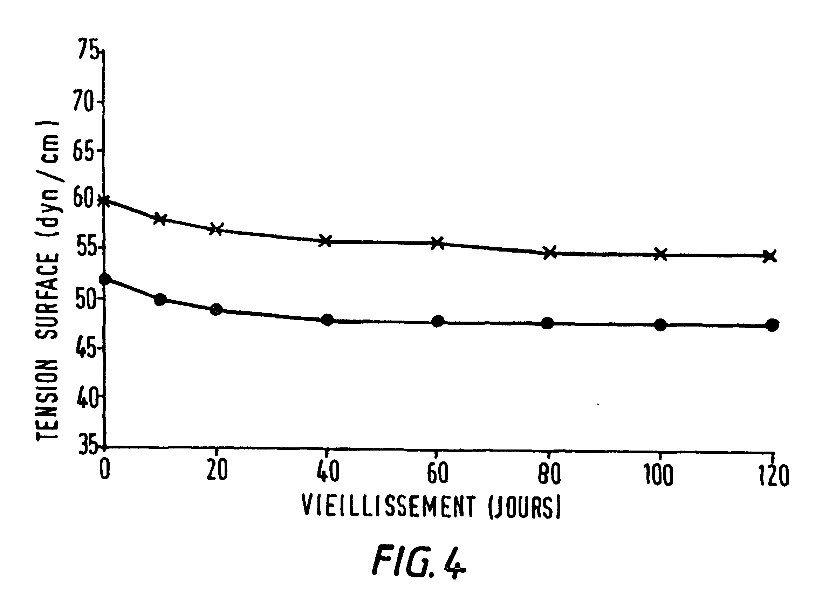

La figure 4 illustre les résultats comparatifs des exemples 1 et 2, après traitement des films de BOPP à l'aide de ces deux types d'atmosphère, en terme de tension de surface du film polymère traité, en fonction du vieillissement du film (le point « 0 » du vieillissement correspondant aux films testés juste en sortie de traiteur 11).

Sur la figure, la courbe avec des points (●) correspond aux résultats obtenus dans l'exemple 1, alors que la courbe avec des croix (**X**) correspond aux résultats obtenus dans l'exemple 2.

Tous ces résultats ont été obtenus en mettant en oeuvre une puissance de décharge de 2 kW, donc avec une densité de puissance de 40 W mn/m² (puissance / (largeur du film x vitesse du film)).

On constate alors sur cette figure les valeurs élevées de tension de surface obtenues, d'ailleurs pour les deux types d'atmosphère de traitement, avec une remarquable stabilité de la tension de surface dans le temps, y compris après plusieurs mois de vieillissement des films traités.

La différence de tension de surface observée entre les deux types d'atmosphère est selon toute vraisemblance, à relier, pour le type de film polymère traité ici, à une chimie différente (espèces créées en surface) se produisant dans les deux cas.

## Revendications

1. Procédé d'élaboration d'un mélange gazeux final comportant un gaz porteur, un gaz oxydant et un silane, à teneur déterminée en chacun des trois composants gazeux, comprenant la mise en oeuvre des étapes suivantes :
a) on réalise un mélange gazeux primaire (14, 1/2) comportant un second gaz neutre et ledit silane, la teneur en silane du mélange gazeux primaire étant inférieure à la limite d'auto-inflammation du silane considéré dans l'air ;
b) on dispose d'un premier courant de gaz, comportant ledit gaz porteur, à teneur résiduelle contrôlée en le dit gaz oxydant;
c) on réalise le mélange final requis selon l'une ou l'autre des deux procédures suivantes, en fonction de la teneur résiduelle en gaz oxydant dudit courant de gaz comportant ledit gaz porteur :
P1 : on mélange (15) ledit premier courant de gaz (4) à un second courant dudit mélange gazeux primaire et à un troisième courant du gaz oxydant (3), dans des proportions permettant d'obtenir le mélange final requis, l'adjonction du courant de gaz oxydant étant effectuée en mode dynamique;
P2 : on mélange le dit premier courant de gaz à un second courant dudit mélange gazeux primaire, dans des proportions permettant d'obtenir le mélange final requis, l'adjonction du courant de mélange primaire étant effectuée en mode dynamique.

2. Procédé selon la revendication 1, caractérisé en ce que le mélange selon la procédure P1 est réalisé en deux étapes :
i) on réalise un mélange intermédiaire, entre ledit premier courant de gaz (4) et le dit second courant de mélange gazeux primaire;
ii) on adjoint ledit troisième courant du gaz oxydant (3) au mélange intermédiaire dans des proportions permettant d'obtenir le mélange final requis.

3. Procédé selon la revendication 1 ou 2 caractérisé en ce que l'on réalise une homogénéisation du mélange final ainsi formé, par le fait que la canalisation (16) où circule ledit premier courant de gaz adopte, en aval des points (22,23) d'adjonction dudit second courant de mélange primaire et dudit troisième courant du gaz oxydant, dans le cas de la procédure P1, ou en aval du point d'adjonction dudit second courant de mélange gazeux primaire, dans le cas de la procédure P2, une forme de serpentin.

4. Procédé selon l'une des revendications 1 à 3 caractérisé en ce que le silane utilisé est le monosilane SiH₄.

5. Procédé selon l'une des revendications précédentes caractérisé en ce que ledit premier courant de gaz est un courant d'azote d'origine cryogénique, et en ce que l'on applique alors la procédure P1.

6. Procédé selon l'une des revendications 1 à 4 caractérisé en ce que ledit premier courant de gaz est un courant d'azote impur obtenu par séparation d'air par perméation ou adsorption, comportant une teneur résiduelle en oxygène et en ce que l'on applique alors la procédure P2.

7. Procédé selon la revendication 6, caractérisé en ce que la teneur résiduelle en oxygène du dit premier courant de gaz est comprise entre 0,1 % et 12 % volumiques.

8. Procédé selon l'une des revendications 1 à 4 caractérisé en ce que ledit premier courant de gaz est un courant d'air sec, et en ce que l'on applique alors la procédure P2.

9. Procédé selon l'une des revendications 1 à 4 caractérisé en ce que le dit gaz oxydant est l'oxygène ou un gaz comportant de l'oxygène.

10. Procédé selon l'une des revendications 1 à 4 caractérisé en ce que le dit gaz oxydant est le protoxyde d'azote.

11. Procédé selon l'une des revendications précédentes, caractérisé en ce que ledit gaz porteur est un gaz neutre.

12. Procédé selon l'une des revendications 1 à 4, caractérisé en ce que ledit gaz porteur est un mélange d'un gaz neutre et d'un gaz réducteur.

13. Procédé selon la revendication 11, caractérisé en ce que ledit gaz porteur neutre et le dit second gaz neutre sont identiques.

14. Procédé selon l'une des revendications précédentes caractérisé en ce que le mélange gazeux final ainsi formé est dirigé vers au moins un poste utilisateur où est pratiquée une opération de traitement de surface de films polymères par dépôt d'une couche à base de silicium sous décharge électrique à barrière diélectrique.

15. Procédé selon l'une des revendications précédentes, caractérisé en ce que dans le cas où l'on applique la procédure P1, la vitesse du gaz dans la canalisation où circule le dit premier courant de gaz est supérieure à la vitesse de gaz dans la canalisation où circule le dit troisième courant de gaz oxydant, et en ce que dans le cas où l'on applique la procédure P2, la vitesse du gaz dans la canalisation où circule le dit premier courant de gaz est supérieure à la vitesse du gaz dans la canalisation où circule le dit second courant de mélange primaire.

16. Procédé selon la revendication 15, caractérisé en ce que dans le cas où l'on applique la procédure P1, le rapport **X** entre la vitesse de gaz dans la canalisation où circule le dit premier courant de gaz et la vitesse de gaz dans la canalisation où circule le dit troisième courant de gaz oxydant est compris entre 1 et 300.

17. Procédé selon la revendication 15, caractérisé en ce que dans le cas où l'on applique la procédure P2, le rapport **X** entre la vitesse de gaz dans la canalisation où circule le dit premier courant de gaz et la vitesse de gaz dans la canalisation où circule le dit second courant de mélange primaire est compris entre 1 et 300.

18. Installation d'élaboration d'un mélange gazeux final comportant un gaz porteur, un gaz oxydant et un silane, à teneur déterminée en chacun des trois composants gazeux, comportant :
- une source de gaz, comportant ledit gaz porteur, à teneur résiduelle contrôlée en le dit gaz oxydant;
- une source d'un mélange gazeux primaire (14, 1/2) comportant un second gaz neutre et ledit silane, la teneur en silane du mélange gazeux primaire étant inférieure à la limite d'auto-inflammation du silane considéré dans l'air ;
- le cas échéant, une source du dit gaz oxydant (3), selon la teneur résiduelle en gaz oxydant de ladite source de gaz comportant ledit gaz porteur ;
- une zone de mélange (15) apte à réaliser le mélange final requis;
caractérisée en ce que la dite zone de mélange comporte une première canalisation (16) apte à y faire circuler un premier courant dudit gaz comportant ledit gaz porteur, et une seconde canalisation (18) apte à y faire circuler un second courant de mélange gazeux primaire, et le cas échéant une troisième canalisation (17) apte à y faire circuler un troisième courant dudit gaz oxydant, les seconde et troisième canalisations débouchant en leur partie aval dans la première canalisation, et en ce que les canalisations sont dimensionnées de façon telle que la vitesse de gaz dans la première canalisation puisse être supérieure à la vitesse de gaz dans au moins l'une des autres canalisations.

19. Installation selon la revendication 18, caractérisée en ce que les canalisations sont dimensionnées de façon telle que le rapport **X** entre la vitesse de gaz dans la première canalisation et la vitesse de gaz dans la troisième canalisation soit compris entre 1 et 300.

20. Installation selon la revendication 18, caractérisée en ce que les canalisations sont dimensionnées de façon telle que le rapport **X** entre la vitesse de gaz dans la première canalisation et la vitesse de gaz dans la seconde canalisation soit compris entre 1 et 300.

21. Installation selon l'une des revendications 18 à 20, caractérisée en ce que ladite première canalisation (16) adopte, en aval des points (22,23) de connexion des seconde et troisième canalisations sur la première canalisation, une forme de serpentin.

22. Installation selon l'une des revendications 18 à 21, caractérisée en ce que ladite source de mélange gazeux primaire est constituée de bouteilles de mélange pre-effectué second gaz neutre/silane.

23. Installation selon l'une des revendications 18 à 21, caractérisée en ce qu'elle comprend une source de silane pur (2) et une source (1) de second gaz neutre, et en ce que ladite source de mélange gazeux primaire est obtenue par mélange entre du silane en provenance de ladite source de silane pur et du gaz neutre en provenance de ladite source (1) de second gaz neutre.

24. Installation selon la revendication 23, caractérisée en ce que ladite source de mélange gazeux primaire est constituée d'une capacité tampon (8).

25. Installation selon l'une des revendications 18 à 24, caractérisée en ce que le dit silane est le monosilane.

26. Installation selon l'une des revendications 18 à 25, caractérisée en ce que ladite source de gaz oxydant est de l'oxygène ou de l'air ou du protoxyde d'azote.

27. Installation selon l'une des revendications 18 à 26, caractérisée en ce que ladite source de gaz comportant ledit gaz porteur, est de l'azote d'origine cryogénique.

28. Installation selon l'une des revendications 18 à 26, caractérisée en ce que ladite source de gaz comportant ledit gaz porteur, est de l'azote impur obtenu par séparation d'air par perméation ou adsorption, dont la teneur résiduelle en oxygène est comprise entre 0,1 et 12 % volumiques.

29. Installation selon l'une des revendications 18 à 26, caractérisée en ce que ladite source de gaz, comportant ledit gaz porteur, est de l'air sec.

## Patentansprüche

1. Verfahren zur Herstellung eines ein Trägergas, ein Oxidationsgas und ein Silan enthaltenden Endgasgemischs mit einem vorgegebenen Gehalt an jedem der drei Gasbestandteile, bei dem man:
a) ein Primärgasgemisch (14, 1/2), das ein zweites Neutralgas und das Silan enthält, herstellt, wobei der Silangehalt des Primärgasgemischs unter der Selbstentzündungsgrenze des in Rede stehenden Silans in Luft liegt;
b) einen ersten Gasstrom, der das Trägergas mit kontrolliertem Oxidationsgas-Restgehalt enthält, bereitstellt;
c) das gewünschte Endgasgemisch in Abhängigkeit vom Oxidationsgas-Restgehalt des das Trägergas enthaltenden Gasstroms nach einer der beiden folgenden Verfahrensweisen herstellt:
V1: man mischt (15) den ersten Gasstrom (4) mit einem zweiten Strom des Primärgasgemischs und einem dritten Strom des Oxidationsgases (3) in Anteilen, mit denen das gewünschte Endgemisch erhältlich ist, wobei die Zugabe des Oxidationsgasstroms dynamisch erfolgt;
V2: man mischt den ersten Gasstrom mit einem zweiten Strom des Primärgasgemischs in Anteilen, mit denen das gewünschte Endgemisch erhältlich ist, wobei die Zugabe des Primärgemischstroms dynamisch erfolgt.

2. Verfahren nach Anspruch 1, dadurch gekennzeichnet, daß man das Gemisch gemäß Verfahrensweise V1 in zwei Schritten herstellt:
i) man stellt aus dem ersten Gasstrom (4) und dem zweiten Strom des Primärgasgemischs ein Zwischengemisch her;
ii) man setzt dem Zwischengemisch den dritten Strom des Oxidationsgases (3) in Anteilen, mit denen das gewünschte Endgemisch erhältlich ist, zu.

3. Verfahren nach Anspruch 1 oder 2, dadurch gekennzeichnet, daß das so gebildete Endgemisch dadurch homogenisiert wird, daß die Rohrleitung (16), die von dem ersten Gasstrom durchströmt wird, im Fall der Verfahrensweise V1 hinter den Punkten (22, 23) zur Zugabe des zweiten Primärgemischstroms und des dritten Stroms des Oxidationsgases bzw. im Fall der Verfahrensweise V2 hinter dem Punkt zur Zugabe des zweiten Primärgasgemischstroms schlangenförmig ausgebildet ist.

4. Verfahren nach einem der Ansprüche 1 bis 3, dadurch gekennzeichnet, daß man als Silan Monosilan SiH₄ einsetzt.

5. Verfahren nach einem der vorhergehenden Ansprüche, dadurch gekennzeichnet, daß man als ersten Gasstrom einen Strom von kryogen erzeugtem Stickstoff einsetzt und dann nach Verfahrensweise V1 vorgeht.

6. Verfahren nach einem der Ansprüche 1 bis 4, dadurch gekennzeichnet, daß man als ersten Gasstrom einen Strom von durch permeative oder adsorptive Luftzerlegung erhaltenem unreinem Stickstoff mit einem Sauerstoffrestgehalt einsetzt und dann nach Verfahrensweise V2 vorgeht.

7. Verfahren nach Anspruch 6, dadurch gekennzeichnet, daß der Sauerstoffrestgehalt des ersten Gasstroms zwischen 0,1 und 12 Vol.-% liegt.

8. Verfahren nach einem der Ansprüche 1 bis 4, dadurch gekennzeichnet, daß man als ersten Gasstrom einen Trockenluftstrom einsetzt und dann nach Verfahrensweise V2 vorgeht.

9. Verfahren nach einem der Ansprüche 1 bis 4, dadurch gekennzeichnet, daß man als Oxidationsgas Sauerstoff oder ein sauerstoffhaltiges Gas einsetzt.

10. Verfahren nach einem der Ansprüche 1 bis 4, dadurch gekennzeichnet, daß man als Oxidationsgas Distickstoffmonoxid einsetzt.

11. Verfahren nach einem der vorhergehenden Ansprüche, dadurch gekennzeichnet, daß man als Trägergas ein Neutralgas einsetzt.

12. Verfahren nach einem der Ansprüche 1 bis 4, dadurch gekennzeichnet, daß man als Trägergas ein Gemisch aus einem Neutralgas und einem Reduktionsgas einsetzt.

13. Verfahren nach Anspruch 11, dadurch gekennzeichnet, daß das Trägerneutralgas und das zweite Neutralgas identisch sind.

14. Verfahren nach einem der vorhergehenden Ansprüche, dadurch gekennzeichnet, daß man das so gebildete Endgasgemisch mindestens einer Verbrauchsstelle zuführt, an der Polymerfolien einer Oberflächenbehandlung unterzogen werden, bei der eine auf Silicium basierende Schicht unter dielektrisch behinderter elektrischer Entladung aufgebracht wird.

15. Verfahren nach einem der vorhergehenden Ansprüche, dadurch gekennzeichnet, daß im Fall der Anwendung von Verfahrensweise V1 die Gasgeschwindigkeit in der Rohrleitung, die von dem ersten Gasstrom durchströmt wird, größer ist als die Gasgeschwindigkeit in der Rohrleitung, die von dem dritten Oxidationsgasstrom durchströmt wird, und im Fall der Anwendung von Verfahrensweise V2 die Gasgeschwindigkeit in der Rohrleitung, die von dem ersten Gasstrom durchströmt wird, größer ist als die Gasgeschwindigkeit in der Rohrleitung, die von dem zweiten Primärgemischstrom durchströmt wird.

16. Verfahren nach Anspruch 15, dadurch gekennzeichnet, daß im Fall der Anwendung von Verfahrensweise V1 das Verhältnis X zwischen der Gasgeschwindigkeit in der Rohrleitung, die von dem ersten Gasstrom durchströmt wird, und der Gasgeschwindigkeit in der Rohrleitung, die von dem dritten Oxidationsgasstrom durchströmt wird, zwischen 1 und 300 liegt.

17. Verfahren nach Anspruch 15, dadurch gekennzeichnet, daß im Fall der Anwendung von Verfahrensweise V2 das Verhältnis X zwischen der Gasgeschwindigkeit in der Rohrleitung, die von dem ersten Gasstrom durchströmt wird, und der Gasgeschwindigkeit in der Rohrleitung, die von dem zweiten Primärgemischstrom durchströmt wird, zwischen 1 und 300 liegt.

18. Vorrichtung zur Herstellung eines ein Trägergas, ein Oxidationsgas und ein Silan enthaltenden Endgasgemischs mit einem vorgegebenen Gehalt an jedem der drei Gasbestandteile, enthaltend:
- eine Quelle eines Gases, das das Trägergas mit kontrolliertem Oxidationsgas-Restgehalt enthält;
- eine Quelle eines Primärgasgemischs (14, 1/2), das ein zweites Neutralgas und das Silan enthält, wobei der Silangehalt des Primärgasgemischs unter der Selbstentzündungsgrenze des in Rede stehenden Silans in Luft liegt;
- je nach Oxidationsgas-Restgehalt der Quelle des das Trägergas enthaltenden Gases gegebenenfalls eine Quelle des Oxidationsgases (3);
- eine Mischzone (15) zur Herstellung des gewünschten Endgemischs;
dadurch gekennzeichnet, daß die Mischzone eine erste Rohrleitung (16), die von einem ersten Strom des das Trägergas enthaltenden Gases durchströmt werden kann, und eine zweite Rohrleitung (18), die von einem zweiten Primärgasgemischstrom durchströmt werden kann, und gegebenenfalls eine dritte Rohrleitung (17), die von einem dritten Strom des Oxidationsgases durchströmt werden kann, aufweist, wobei die zweite und dritte Rohrleitung mit ihrem hinteren Teil in die erste Rohrleitung münden, und die Rohrleitungen so dimensioniert sind, daß die Gasgeschwindigkeit in der ersten Rohrleitung größer als die Gasgeschwindigkeit in mindestens einer der anderen Rohrleitungen sein kann.

19. Vorrichtung nach Anspruch 18, dadurch gekennzeichnet, daß die Rohrleitungen so dimensioniert sind, daß das Verhältnis X zwischen der Gasgeschwindigkeit in der ersten Rohrleitung und der Gasgeschwindigkeit in der dritten Rohrleitung zwischen 1 und 300 liegt.

20. Vorrichtung nach Anspruch 18, dadurch gekennzeichnet, daß die Rohrleitungen so dimensioniert sind, daß das Verhältnis X zwischen der Gasgeschwindigkeit in der ersten Rohrleitung und der Gasgeschwindigkeit in der zweiten Rohrleitung zwischen 1 und 300 liegt.

21. Vorrichtung nach einem der Ansprüche 18 bis 20, dadurch gekennzeichnet, daß die erste Rohrleitung (16) hinter den Punkten (22, 23) zur Verbindung der zweiten und dritten Rohrleitung mit der ersten Rohrleitung schlangenförmig ausgebildet ist.

22. Vorrichtung nach einem der Ansprüche 18 bis 21, dadurch gekennzeichnet, daß es sich bei der Primärgasgemischquelle um Flaschen mit vorher hergestelltem Gemisch aus zweitem Neutralgas und Silan handelt.

23. Vorrichtung nach einem der Ansprüche 18 bis 21, dadurch gekennzeichnet, daß sie eine Quelle von Reinsilan (2) und eine Quelle (1) von zweitem Neutralgas aufweist, und daß die Primärgasgemischquelle durch Mischen des Silans aus der Reinsilanquelle und des Neutralgases aus der Quelle (1) von zweitem Neutralgas erhalten wird.

24. Vorrichtung nach Anspruch 23, dadurch gekennzeichnet, daß es sich bei der Primärgasgemischquelle um einen Pufferbehälter (8) handelt.

25. Vorrichtung nach einem der Ansprüche 18 bis 24, dadurch gekennzeichnet, daß es sich bei dem Silan um Monosilan handelt.

26. Vorrichtung nach einem der Ansprüche 18 bis 25, dadurch gekennzeichnet, daß es sich bei der Oxidationsgasquelle um Sauerstoff, Luft oder Distickstoffmonoxid handelt.

27. Vorrichtung nach einem der Ansprüche 18 bis 26, dadurch gekennzeichnet, daß es sich bei der Quelle des das Trägergas enthaltenden Gases um kryogen erzeugten Stickstoff handelt.

28. Vorrichtung nach einem der Ansprüche 18 bis 26, dadurch gekennzeichnet, daß es sich bei der Quelle des das Trägergas enthaltenden Gases um durch permeative oder adsorptive Luftzerlegung erhaltenen unreinen Stickstoff mit einem Sauerstoffrestgehalt zwischen 0,1 und 12 Vol.-% handelt.

29. Vorrichtung nach einem der Ansprüche 18 bis 26, dadurch gekennzeichnet, daß es sich bei der Quelle des das Trägergas enthaltenden Gases um Trockenluft handelt.

## Claims

1. Process for the production of a final gaseous mixture containing a carrier gas, an oxidizing gas and a silane, with a predetermined content of each of the three gaseous components, comprising the implementation of the following stages:
a) a primary gaseous mixture (14, 1/2) containing a second neutral gas and the said silane is prepared, the silane content in the primary gaseous mixture being below the self-ignition limit of that particular silane in air;
b) a first gas stream, containing the said carrier gas, with a controlled residual content of the said oxidizing gas, is available;
c) the required final mixture is prepared according to one or other of the following two procedures, as a function of the residual content of oxidizing gas in the said gas stream containing the said carrier gas:
P1: the said first gas stream (4) is mixed (15) with a second stream of the said primary gaseous mixture and with a third stream of the oxidizing gas (3), in proportions which make it possible to obtain the required final mixture, the addition of the oxidizing gas stream being carried out under dynamic conditions;
P2: the said first gas stream is mixed with a second stream of the said primary gaseous mixture, in proportions which make it possible to obtain the required final mixture, the addition of the primary mixture stream being carried out under dynamic conditions.

2. Process according to Claim 1, characterized in that the mixing according to the procedure P1 is carried out in two stages:
i) an intermediate mixture between the said first gas stream (4) and the said primary gaseous mixture second stream is prepared; and
ii) the said third stream of the oxidizing gas (3) is added to the intermediate mixture in proportions which make it possible to obtain the required final mixture.

3. Process according to Claim 1 or 2, characterized in that the final mixture thus formed is homogenized due to the fact that the pipe (16) in which the said first gas stream moves adopts, downstream of the points (22, 23) for addition of the said primary mixture second stream and of the said third stream of the oxidizing gas, in the case of the procedure P1, or downstream of the point for addition of the said primary gaseous mixture second stream, in the case of the procedure P2, a coil shape.

4. Process according to one of Claims 1 to 3, characterized in that the silane used is- monosilane SiH₄.

5. Process according to one of the preceding claims, characterized in that the said first gas stream is a nitrogen stream of cryogenic origin and in that the procedure P1 is then applied.

6. Process according to one of Claims 1 to 4, characterized in that the said first gas stream is an impure nitrogen stream obtained by separation from air by permeation or adsorption, containing a residual oxygen content, and in that the procedure P2 is then applied.

7. Process according to Claim 6, characterized in that the residual oxygen content in the said first gas stream is between 0.1% and 12% by volume.

8. Process according to one of Claims 1 to 4, characterized in that the said first gas stream is a dry air stream and in that the procedure P2 is then applied.

9. Process according to one of Claims 1 to 4, characterized in that the said oxidizing gas is oxygen or a gas containing oxygen.

10. Process according to one of Claims 1 to 4, characterized in that the said oxidizing gas is nitrous oxide.

11. Process according to one of the preceding claims, characterized in that the said carrier gas is a neutral gas.

12. Process according to one of Claims 1 to 4, characterized in that the said carrier gas is a mixture of a neutral gas and of a reducing gas.

13. Process according to Claim 11, characterized in that the said neutral carrier gas and the said second neutral gas are identical.

14. Process according to one of the preceding claims, characterized in that the final gaseous mixture thus formed is directed to at least one user point where a surface treatment operation is performed on polymer films by deposition of a silicon-based layer, under dielectric-barrier electrical discharge.

15. Process according to one of the preceding claims, characterized in that, in the case where the procedure P1 is applied, the gas velocity in the pipe in which the said first gas stream moves is greater than the gas velocity in the pipe in which the said oxidizing gas third stream moves and in that, in the case where the procedure P2 is applied, the gas velocity in the pipe in which the said first gas stream moves is greater than the gas velocity in the pipe in which the said primary mixture second stream moves.

16. Process according to Claim 15, characterized in that, in the case where the procedure P1 is applied, the ratio X of the gas velocity in the pipe in which the said first gas stream moves to the gas velocity in the pipe in which the said oxidizing gas third stream moves is between 1 and 300.

17. Process according to Claim 15, characterized in that, in the case where the procedure P2 is applied, the ratio X of the gas velocity in the pipe in which the said first gas stream moves to the gas velocity in the pipe in which the said primary mixture second stream moves is between 1 and 300.

18. Plant for the production of a final gaseous mixture containing a carrier gas, an oxidizing gas and a silane, with a predetermined content of each of the three gaseous components, comprising:
- a gas source, containing the said carrier gas, with a controlled residual content of the said oxidizing gas;
- a source of a primary gaseous mixture (14, 1/2) containing a second neutral gas and the said silane, the silane content in the primary gaseous mixture being below the self-ignition limit of that particular silane in air;
- if appropriate, a source of the said oxidizing gas (3), depending on the residual content of oxidizing gas in the said gas source containing the said carrier gas;
- a mixing region (15) capable of producing the required final mixture;
characterized in that the said mixing region contains a first pipe (16) capable of making a first stream of the said gas containing the said carrier gas move and a second pipe (18) capable of making a primary gaseous mixture second stream move and, if appropriate, a third pipe (17) capable of making a third stream of the said oxidizing gas move, the second and third pipes emerging at their downstream part in the first pipe, and in that the dimensions of the pipes are arranged in such a way that the gas velocity in the first pipe can be greater than the gas velocity in at least one of the other pipes.

19. Plant according to Claim 18, characterized in that the dimensions of the pipes are arranged in such a way that the ratio **X** of the gas velocity in the first pipe to the gas velocity in the third pipe is between 1 and 300.

20. Plant according to Claim 18, characterized in that the dimensions of the pipes are arranged in such a way that the ratio **X** of the gas velocity in the first pipe to the gas velocity in the second pipe is between 1 and 300.

21. Plant according to one of Claims 18 to 20, characterized in that the said first pipe (16) adopts, downstream of the points (22, 23) for connection of the second and third pipes to the first pipe, a coil shape.

22. Plant according to one of Claims 18 to 21, characterized in that the said primary gaseous mixture source is composed of bottles of second neutral gas/silane preprepared mixture.

23. Plant according to one of Claims 18 to 21, characterized in that it comprises a pure silane source (2) and a second neutral gas source (1) and in that the said primary gaseous mixture source is obtained by mixing between the silane originating from the said pure silane source and the neutral gas originating from the said second neutral gas source (1).

24. Plant according to Claim 23, characterized in that the said primary gaseous mixture source is composed of a buffer tank (8).

25. Plant according to one of Claims 18 to 24, characterized in that the said silane is monosilane.

26. Plant according to one of Claims 18 to 25, characterized in that the said oxidizing gas source is oxygen or air or nitrous oxide.

27. Plant according to one of Claims 18 to 26, characterized in that the said gas source containing the said carrier gas is nitrogen of cryogenic origin.

28. Plant according to one of Claims 18 to 26, characterized in that the said gas source containing the said carrier gas is impure nitrogen obtained by separation from air by permeation or adsorption, the residual oxygen content of which is between 0.1 and 12% by volume.

29. Plant according to one of Claims 18 to 26, characterized in that the said gas source containing the said carrier gas is dry air.
